# EUROPEAN PATENT APPLICATION

(11) **EP 2 882 270 A1**
(43) Date of publication of application: **10.06.2015**
(21) Application number: 12882555.1
(22) Date of filing: 06.08.2012
(51) Int. Cl.: H05K 7/20, H01L 23/34

(54) **APPARATUS FOR DISSIPATING HEAT THROUGH HEAT SINK**

(71) Applicant: KMW Inc., Gyeonggi-do 445-813 (KR)
(72) Inventor: KIM, Duk-Yong, Hwaseong-si Gyeonggi-do 445-813 (KR); YOO, Chang-Woo, Hwaseong-si Gyeonggi-do 445-813 (KR); RYU, Chi-Back, Hwaseong-si Gyeonggi-do 445-813 (KR); PARK, Min-Sik, Hwaseong-si Gyeonggi-do 445-813 (KR)
(74) Representative: Müller Hoffmann & Partner
(86) International application number: PCT/KR2012/006246
(87) International publication number: WO 2014/025074

(57) **Abstract**

The present invention is an apparatus for dissipating heat through a heat sink, the apparatus comprising: a heat transfer member having one end with a contact surface contacting a heating element arranged on a substrate and the other end with a contact surface contacting the heat sink, the heat transfer member transferring the heat generated from the heating element to the heat sink; an elastic member for providing elastic force for pushing the heat transfer member toward the heating element; a guide member arranged in the heat sink to form a contact surface contacting the heat transfer member, the guide member mechanically guiding the heat transfer member such that the heat transfer member may slide and move toward the heating element; and a spacing member inserted between the substrate and the heat sink so as to maintain a preset spacing when the substrate and the heat sink are fixed and attached with each other.

## Description

### Detailed Description of the Invention

### Technical Field

The present invention relates to a heat-dissipating apparatus, and more particularly, to an apparatus of dissipating heat through a heat sink, which can be used in various electrical and electronic apparatuses with a heat sink for dissipating heat.

### Background Art

In general, some kinds of electrical or electronic devices include heating members that generate a large amount of heat, and need a heat-dissipating structure for efficiently dissipating heat generated from such heating members. For example, a high-power, high-output amplifier, a high-speed, high-functional Central Processing Unit (CPU), a Digital Signal Processor (DSP), and a Field Programmable Gate Array (FPGA), generate a relatively large amount of heat. The generated heat may degrade the performance of the corresponding member or apparatus, or become a main factor of causing a malfunction or part damage.

### Disclosure

### Technical Problem

In order to dissipate heat generated from a heating member, an apparatus requiring heat dissipation generally installs a heat sink with a plurality of heat-dissipating fins therein. Generally, the heat-dissipating efficiency of the heat sink increases in proportion to the number of the fins and the entire area of the heat sink. However, due to requirements for miniaturization and weight lightening of an apparatus in which the heat sink is installed, the design of the heat sink is limited. Particularly, miniaturization and weight lightening are very important in a mobile communication base station, a repeater, etc., which are installed at a high place.

Accordingly, technologies for improving heat-dissipating efficiency while meeting requirements for miniaturization and weight lightening are developed in various ways.

### Technical Solution

An aspect of the present invention provides an apparatus for dissipating heat through a heat sink, which is capable of achieving miniaturization and weight lightening while improving heat-dissipating efficiency.

Another aspect of the present disclosure provides an apparatus for dissipating heat through a heat sink, which is capable of inducing efficient heat-dissipating for each heating device.

In accordance with an aspect of exemplary embodiments of the present disclosure, there is provided an apparatus for dissipating heat through a heat sink, including: a heat transfer member having one end with a contact surface contacting a heating device mounted on a substrate and the other end with a contact surface contacting the heat sink, and configured to transfer heat generated from the heating device to the heat sink; an elastic member configured to provide an elastic force for pushing the heat transfer member toward the heating device; a guide member arranged in the heat sink to form a contact surface contacting the heat transfer member, and configured to mechanically guide the heat transfer member to slide toward the heating device; and a spacing member interposed between the substrate and the heat sink to maintain a predetermined spacing between the substrate and the heat sink when the heat sink is fixedly attached on the substrate.

### Advantageous Effects

As described above, the apparatus of dissipating heat through the heat sink, according to the present disclosure, can achieve miniaturization and weight lightening while improving heat-dissipating efficiency, and induce efficient heat-dissipating for each heating device.

### BRIEF DESCRIPTION OF THE DRAWINGS

FIG. 1 is an exploded perspective view of an apparatus of dissipating heat through a heat sink, according to a first embodiment of the present disclosure;
FIG. 2 is a cross-sectional view cut along a line A-A' of FIG. 1;
FIG. 3 is an assembly view of FIG. 2;
FIG. 4 is a structure view of an apparatus of dissipating heat through a heat sink, according to a second embodiment of the present disclosure;
FIG. 5 is a structure view of an apparatus of dissipating heat through a heat sink, according to a third embodiment of the present disclosure; and
FIG. 6 is a structure view of an apparatus of dissipating heat through a heat sink, according to a fourth embodiment of the present disclosure.

### Best Mode

Now, preferred embodiments of the present disclosure will be described in detail with reference to the accompanying drawings. Like numbers refer to like elements throughout the accompanying drawings. Also, in the following description, specific configurations of a heat sink, heat transfer members, elastic members, guide members, etc., are provided to help the understanding of the present disclosure, and accordingly, the specific configurations can be modified or changed within the scope of the present disclosure.

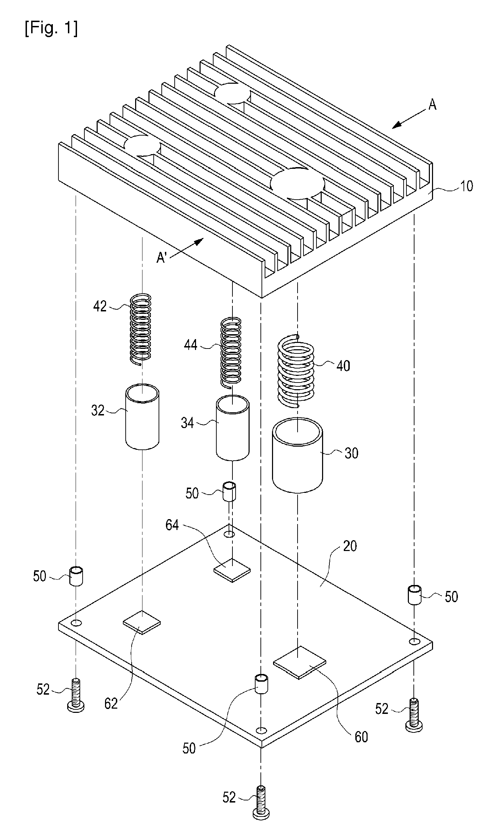

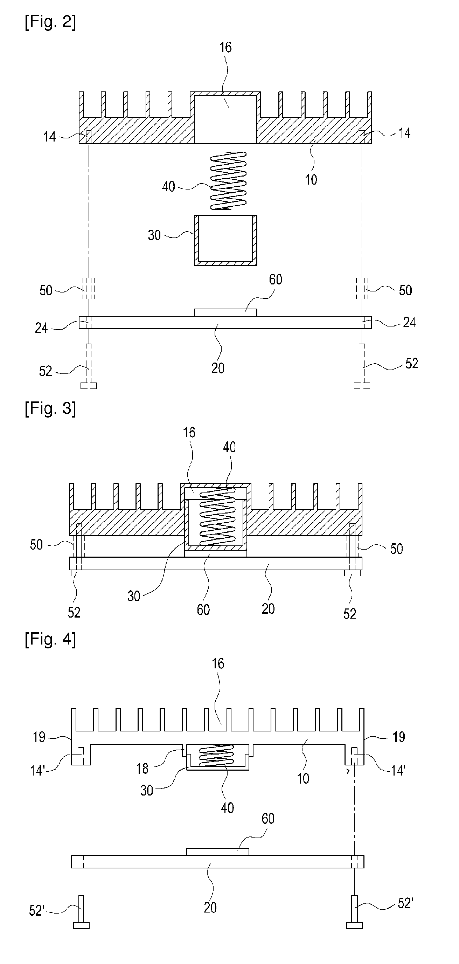

FIG. 1 is an exploded perspective view of an apparatus of dissipating heat through a heat sink, according to a first embodiment of the present disclosure, FIG. 2 is a cross-sectional view cut along a line A-A' of FIG. 1, and FIG. 3 is an assembly view of FIG. 2. Referring to FIGS. 1, 2, and 3, the heat-dissipating apparatus according to the first embodiment of the present disclosure may include a plurality of heat transfer members 30, 32, and 34. The heat transfer members 30, 32, and 34 may be respectively installed to correspond to a plurality of heating devices 60, 62, and 64 of various shapes mounted on a substrate 20, when a heat sink 10 is fixedly attached on the substrate 20, such that one ends of the heat transfer members 30, 32, and 34 have contact surfaces contacting the corresponding heating devices 60, 62, and 64, and the other ends of the heat transfer members 30, 32, and 34 have contact surfaces contacting the heat sink 10 to thereby transfer heat generated from the heating devices 30, 32, and 34 to the heat sink 10.

Also, the heat-dissipating apparatus may include a plurality of elastic members 40, 42, and 44 that are installed to correspond to the respective heat transfer members 30, 32, and 34 and that provide elastic forces for pushing the heat transfer members 30, 32, and 34 toward the corresponding heating devices 60, 62, and 54. Each of the elastic members 40, 42, and 44 may be implemented with a coil string structure, however, may be implemented with a flat spring or an elastic body made of a rubber material.

Also, the heat sink 10 may include a plurality of guide members 16 (see FIGS. 2 and 3) that are formed to correspond to the respective heat transfer members 30, 32, and 34, that have contact surfaces contacting the corresponding heat transfer members 30, 32, and 34, and that mechanically guide the corresponding heat transfer members 30, 32, and 34 to slide toward the corresponding heating devices 60, 62, and 64.

Each of the heat transfer members 30, 32, and 34 may be in the shape of a cylindrical tube with a groove into which the corresponding elastic member 40, 42, or 44 is inserted. Also, each of the guide members 16 may have a round groove structure whose diameter matches the diameter of the corresponding heat transfer member 30, 32, or 34, such that the corresponding heat transfer member 30, 32, or 34 (with the elastic member 40, 42, or 44) can be inserted into the guide member 16, the side surface of the corresponding heat transfer member 30, 32, or 34 in the shape of the cylindrical tube contacting the guide member 16.

However, the heat transfer members may have any other shapes than the cylinder shape, and accordingly, the guide members may also have various shapes. Also, the heat transfer members may have sizes matching the sizes of the corresponding heating devices, and may have different shapes in correspondence to the shapes of the heating devices.

Meanwhile, the heat sink 10 may be fixedly attached on the substrate 20 through screw coupling by a plurality of screws 52. In order to maintain a predetermined spacing between the heat sink 10 and the substrate 20 when the heat sink 10 is coupled with the substrate 20, a plurality of spacing members 50 may be interposed between the heat sink 10 and the substrate 20. The spacing members 50 may include holes that the screws 52 can penetrate. The screws 52 may be coupled with screw holes 14 formed at the corresponding locations in the heat sink 10 through holes formed in the substrate 20 and the holes formed in the spacing members 50, thereby fixedly attaching the heat sink 10 on the substrate 20.

As such, if the substrate 20 and the heat sink 10 are fixedly attached with each other with an appropriate spacing by the spacing members 50, one end of the heat transfer member 30 may contact the heating device 60, and the other end of the heat transfer member 30 may be pushed into the guide member 16. In this state, the heat transfer member 30 may maintain a contact to the heating device 60 by the elastic member 40.

The lengths of the heat transfer member 30 and the guide member 16 may be appropriately set so as to provide space into which the heat transfer member 30 can be pushed to some extent in the guide member 14 even after the heat sink 10 is fixedly attached on the substrate 20. If the space is not provided, significant pressure is applied to the heating device 60 through the heat transfer member 30 due to component tolerances or manufacturing tolerances, resulting in a damage of the heating device 60.

Likewise, an elastic force of the elastic member 40 may also be appropriately set so as to apply little pressure to the heating device 60 as possible while maintaining a contact of the heat transfer member 30 to the heating device 60 in a use environment.

Also, if a plurality of heating devices having different heights are mounted on the substrate, the lengths of the heat transfer members and the guide members and the elastic forces of the elastic members may be set to different values to correspond to the respective heating devices.

According to the configuration as described above, heat generated from the plurality of heating devices 60, 62, and 64 may be rapidly transferred to the heat sink 14 through the plurality of heat transfer members 30, 32, and 34, thereby significantly increasing heat-dissipating efficiency.

In the structure described above, appropriately applying thermal paste, such as thermal grease or thermal compound, on the contact surfaces of the heat transfer members to the heating devices and on the contact surfaces of the heat transfer members to the guide members may effectively increase thermal conductivity.

FIG. 4 is a structure view of an apparatus of dissipating heat through a heat sink, according to a second embodiment of the present disclosure. Referring to FIG. 4, a structure of the heat dissipating apparatus according to the second embodiment of the present disclosure is similar to the structure according to the first embodiment as shown in FIGS. 1, 2, and 3, except for the configuration of a guide member 18 formed in the heat sink 10.

That is, in the heat dissipating apparatus according to the second embodiment of the present disclosure, the guide member 18 may be in the shape of a cylindrical tube having a diameter that matches the diameter of the corresponding heat transfer member 30 in the shape of a cylindrical tube such that the heat transfer member 30 can be inserted into the guide member 18. The guide member 18 may protrude from the inner surface of the heat sink 10.

Also, a plurality of spacing members 51 that are interposed between the substrate 20 and the heat sink 10 in order to maintain a predetermined spacing between the substrate 20 and the heat sink 10 when the heat sink 20 is coupled with the substrate 10 may be integrated into the heat sink 10. A plurality of screws holes 14' into which a plurality of screws 52' are screwed may be formed in the integrated-type spacing members 51. The plurality of screws 52' may be screwed into the screw holes 14' formed in the integrated-type spacing members 51 through holes formed in the substrate 20, thereby fixedly attaching the heat sink 10 on the substrate 20.

Likewise, in the second embodiment shown in FIG. 4, the lengths of the heat transfer member 30 and the guide member 18 may be appropriately set so as to provide space into which the heat transfer member 30 can be pushed to some extent in the guide member 18 even after the heat sink 10 is fixedly attached on the substrate 20. Accordingly, it is possible to prevent excessive pressure from being applied to the heating device 60.

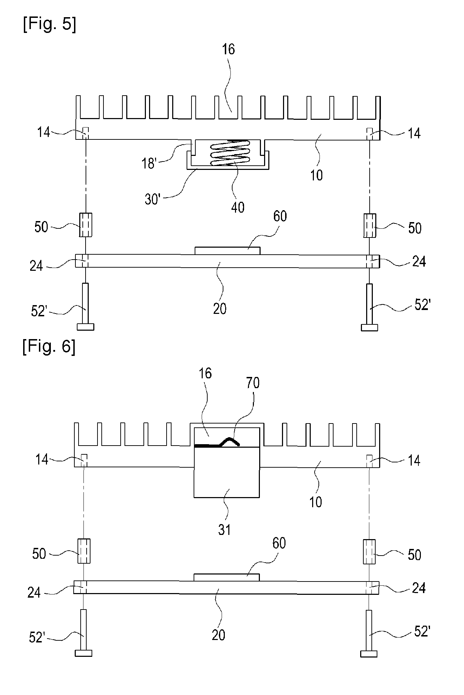

FIG. 5 is a structure view of an apparatus of dissipating heat through a heat sink, according to a third embodiment of the present disclosure. Referring to FIG. 5, a structure of the heat dissipating apparatus according to the third embodiment of the present disclosure is similar to the structure according to the first embodiment as shown in FIGS. 1, 2, and 3, except for the configuration of a guide member 18' formed in the heat sink 10.

In the heat dissipating apparatus according to the third embodiment of the present disclosure, the guide member 18' may be in the shape of a cylindrical tube that protrudes from the inner surface of the heat sink 10, like the second embodiment shown in FIG. 4. However, unlike the second embodiment shown in FIG. 4, the guide member 18' may have a diameter matching the diameter of a heat transfer member 30' in the shape of a cylindrical tube such that the guide member 18' can be inserted into the groove of the heat transfer member 30'.

FIG. 6 is a structure view of an apparatus of dissipating heat through a heat sink, according to a fourth embodiment of the present disclosure. Referring to FIG. 6, a structure of the heat-dissipating apparatus according to the fourth embodiment of the present disclosure is similar to the structure according to the first embodiment as shown in FIGS. 1, 2, and 3, except for the configurations of a heat transfer member 31 and an elastic member 70.

That is, in the heat-dissipating apparatus according to the fourth embodiment of the present disclosure, the heat transfer member 31 may be in the shape of a cylindrical tube without a groove, and the elastic member 70 may have a flat spring structure instead of a coil spring structure.

Configurations of the heat dissipating apparatuses according to the embodiments of the present disclosure have been described above, however, various modifications can be made in the embodiments of the present disclosure without departing from the scope of the present disclosure. For example, in the embodiments of the present disclosure as described above, the guide members have groove structures or protruded cylinder structures. However, a part of the guide members may have groove structures, and the other part of the guide members may have protruded cylinder structures. Also, some of the structures disclosed in any one(s) of the above-described embodiments can be partially applied to the other embodiments. For example, the integrated-type spacing members 51 disclosed in the second embodiment of FIG. 4, the heat transfer member 31 in the shape of the cylindrical tube and the flat spring 70 disclosed in the fourth embodiment of FIG. 6, etc. can be applied to the other embodiments.

It will be apparent to those skilled in the art that various modifications and variations can be made in the present disclosure without departing from the spirit or scope of the disclosures. Thus, it is intended that the present disclosure covers the modifications and variations of this disclosure provided they come within the scope of the appended claims and their equivalents.

## Claims

1. An apparatus for dissipating heat through a heat sink, comprising:
a heat transfer member having one end with a contact surface contacting a heating device mounted on a substrate and the other end with a contact surface contacting the heat sink, and configured to transfer heat generated from the heating device to the heat sink;
an elastic member configured to provide an elastic force for pushing the heat transfer member toward the heating device;
a guide member arranged in the heat sink to form a contact surface contacting the heat transfer member, and configured to mechanically guide the heat transfer member to slide toward the heating device; and
a spacing member interposed between the substrate and the heat sink to maintain a predetermined spacing between the substrate and the heat sink when the heat sink is fixedly attached on the substrate.

2. The apparatus of claim 1, wherein the heat transfer member is in the shape of a tub with a groove into which the elastic member is inserted.

3. The apparatus of claim 2, wherein the guide member is in the shape of a tub having a diameter that matches a diameter of the guide member such that the guide member is inserted into the groove of the guide member while contacting the groove of the guide member, the guide member protruding from the inner surface of the heat sink.

4. The apparatus of claim 1, wherein the guide member includes a groove structure having a diameter that matches a diameter of the heat transfer member such that the heat transfer member is inserted into the groove structure, the side surface of the heat transfer member contacting the groove structure.

5. The apparatus of claim 1, wherein the guide member is in the shape of a tub having a diameter that matches a diameter of the heat transfer member such that the guide member is inserted into the guide member, the side surface of the heat transfer member contacting the guide member, the guide member protruding from the inner surface of the heat sink.

6. The apparatus of claim 1, wherein the guide member is in the shape of a tub having a diameter that matches a diameter of the heat transfer member such that the guide member is inserted into the heat transfer member, the guide member contacting the side surface of the guide member, the guide member protruding from the inner surface of the heat sink.

7. The apparatus of claim 1, wherein the elastic member has a coil spring structure or a flat spring structure.

8. The apparatus of claim 1, wherein the spacing member is integrated into the heat sink.

9. The apparatus of any one of claims 1 to 8, wherein thermal paste is applied on a contact surface of the heat transfer member to the heating device and on a contact surface of the heat transfer member to the guide member.

10. The apparatus of any one of claims 1 to 8, wherein lengths of the heat transfer member and the guide member are set to provide space into which the heat transfer member is further pushed in the guide member after the heat sink is fixedly attached on the substrate.
